(19) Europäisches Patentamt
European Patent Office
Office européen des brevets

(11) **EP 4 036 285 A1**

(12) **EUROPEAN PATENT APPLICATION**
published in accordance with Art. 153(4) EPC

(43) Date of publication:
**03.08.2022 Bulletin 2022/31**

(21) Application number: **20870319.9**

(22) Date of filing: **24.09.2020**

(51) International Patent Classification (IPC):
**C30B 29/36** $^{(2006.01)}$    **C30B 23/06** $^{(2006.01)}$

(52) Cooperative Patent Classification (CPC):
**C30B 23/06; C30B 29/36**

(86) International application number:
**PCT/JP2020/036000**

(87) International publication number:
**WO 2021/060365 (01.04.2021 Gazette 2021/13)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **27.09.2019  JP 2019178045**

(71) Applicants:
• **Kwansei Gakuin Educational Foundation
Nishinomiya-shi, Hyogo 662-8501 (JP)**

• **Toyota Tsusho Corporation
Nagoya-shi
Aichi 450-8575 (JP)**

(72) Inventors:
• **KANEKO, Tadaaki
Sanda-shi, Hyogo 669-1337 (JP)**
• **KOJIMA, Kiyoshi
Tokyo 108-8208 (JP)**

(74) Representative: **dompatent von Kreisler Selting Werner -
Partnerschaft von Patent- und Rechtsanwälten mbB
Deichmannhaus am Dom
Bahnhofsvorplatz 1
50667 Köln (DE)**

(54) **METHOD FOR PRODUCING SEMICONDUCTOR SUBSTRATES AND DEVICE FOR PRODUCING SEMICONDUCTOR SUBSTRATES**

(57)    The present invention attempts to solve the problem of providing novel technology that makes it possible to grow high-quality semiconductor substrates. In order to solve the abovementioned problem, the present invention provides: a method for producing semiconductor substrates that includes an installation step in which starting substrates and starting materials are installed in an alternating manner and a heating step in which the starting substrates and the starting materials are heated and a growth layer is formed on the starting substrates; and a device for producing the semiconductor substrates. Owing to this configuration, the present invention makes it possible to simultaneously achieve desired growth conditions in each of a plurality of starting substrates and thereby provide novel technology that makes it possible to grow high-quality semiconductor substrates.

FIG. 5

**Description**

Technical Field

The present invention relates to a method and an apparatus for producing a semiconductor substrate.

Background Art

Materials such as SiC (silicon carbide), GaN (gallium nitride), and $Ga_2O_3$ (gallium oxide) are attracting attention as next-generation semiconductor materials to replace Si (silicon) and GaAs (gallium arsenide).

For example, compared to Si, SiC has a breakdown electric field that is one order of magnitude larger, a band gap that is three times larger, and a thermal conductivity that is about three times higher. Therefore, SiC is expected to be applied to power devices, high frequency devices, and high temperature operation devices.

Normally, SiC substrates used in the production of SiC semiconductor devices are produced by slicing single crystal SiC ingots. The sublimation recrystallization method (improved Rayleigh's method) is mainly used as the growth method of the ingot (refer to Patent Literature 1).

Citation List

Patent Literature

Patent Literature 1: JP H3-295898 A

Summary of Invention

Technical Problem

In the modified Rayleigh's method, ingot growth proceeds by recrystallization of sublimation gas of a SiC material on the surface of a single crystal substrate (seed crystal). Therefore, the surface after recrystallization (growth) becomes a new growth surface, and this process is repeated to make the ingot longer.

However, in this sublimation recrystallization method, there was a problem that the quality of single crystal SiC varied depending on the part of the ingot because the growth conditions changed from time to time as the growth surface moved. Therefore, it was difficult to grow high-quality single crystal SiC in the entire ingot.

Specifically, since the growth surface of the ingot moves with ingot growth, the distance between the growth surface and the SiC material and the relative position between the growth surface and the heater change. This will result in different growth conditions near the growth surface between the early and late stages of ingot growth.

As a result, high-quality single-crystalline SiC was obtained at one part of the ingot by the desired growth conditions, but at another part of the ingot, the growth conditions deviated from the preferred growth conditions, resulting in the generation of dislocations, contamination with different polymorphs, generation of subgranular boundaries, and the like, and thus high-quality single crystal SiC could not be obtained.

In view of the aforementioned problems, an object of the present invention is to provide a new technology that enables the growth of high-quality semiconductor substrates.

Solution to Problem

In order to solve the above problem, the present invention provides a method for producing a semiconductor substrate including an installation step of alternately installing an base substrate and a source substrate body, and a heating step of heating the base substrate and the source substrate body to form a growth layer on the base substrate. With this configuration, the present invention can provide a novel technology that enables the growth of high-quality semiconductor substrates because the desired growth conditions can be achieved simultaneously in each of a plurality of base substrates.

In a preferred mode of the present invention, the installation step includes installing the base substrate and the source substrate body in a semi-closed space. With this configuration, the present invention can realize source substrate transport between the base substrate and the source substrate body in the desired vapor pressure environment.

In a preferred mode of the present invention, the heating step includes heating the base substrate and the source substrate body so as to form a temperature difference between them. With this configuration, the present invention can realize source substrate transport between the base substrate and the source substrate body that is driven by the temperature gradient between the base substrate and the source substrate body.

A preferred mode of the present invention further includes a separation step of separating a portion of the base substrate having the growth layer. With this configuration, the present invention can separate a high-quality semiconductor substrate from a substrate containing a growth layer.

In a preferred mode of the present invention, the separation step includes an introduction step of introducing a damaged layer into the base substrate having the growth layer, and a peeling step of peeling off a portion of the base substrate having the growth layer. With this configuration, the present invention can introduce a damaged layer at a desired depth from the surface of the base substrate and separate a high-quality semiconductor substrate from the base substrate having the growth layer.

In a preferred mode of the present invention, the installation step includes installing the base substrate and the source substrate body so that they are in close contact with each other. The present invention can provide a novel technology with excellent economic efficiency that can increase the quantity of the base substrate forming the growth layer, and can grow high-quality semiconductor substrates.

In a preferred mode of the present invention, the installation step includes installing a source substrate transport prevention body between the unit objects to be treated including the base substrate and the source substrate body to prevent source substrate transport between the base substrate and the source substrate body. With this configuration, the present invention can achieve crystal growth such that a growth layer is formed on the main surface or the back surface of the base substrate.

In a preferred mode of the present invention, the base substrate and the source substrate body include a SiC material. With this configuration, the present invention can provide a novel technology that enables the growth of high quality SiC semiconductor substrates.

In order to solve the aforementioned problems, the present invention provides an apparatus for producing an base substrate, including a main container in which an base substrate and a source substrate body can be alternately installed, and a heating furnace capable of heating the base substrate and the source substrate body and forming a growth layer on the base substrate. With this configuration, the present invention can provide a novel technology that enables the growth of high-quality semiconductor substrates because the desired growth conditions can be achieved simultaneously in each of a plurality of base substrates.

In a preferred mode of the present invention, the main container has a semi-closed space inside. With this configuration, the present invention can realize source substrate transport between the base substrate and the source substrate body in the desired vapor pressure environment.

In a preferred mode of the present invention, the main container is capable of housing the base substrate, the source substrate body, the source substrate transport prevention body, the base substrate, and the source substrate body that are stacked in this order. With this configuration, the present invention can achieve crystal growth such that a growth layer is formed only on the main surface or the back surface of the base substrate.

In a preferred mode of the present invention, the heating furnace is capable of forming a temperature gradient between the base substrate and the source substrate body. With this configuration, the present invention can realize source substrate transport between the base substrate and the source substrate body that is driven by the temperature gradient between the base substrate and the source substrate body.

A preferred mode of the present invention further includes a separation means capable of separating a portion of the base substrate having the growth layer. With this configuration, the present invention can separate a high-quality semiconductor substrate from a substrate containing a growth layer.

In a preferred mode of the present invention, the separation means includes an introduction means capable of irradiating the base substrate having the growth layer with laser light and introducing a damaged layer to the base substrate having the growth layer, and a peeling means capable of peeling off a portion of the base substrate having the growth layer. With this configuration, the present invention can introduce a damaged layer from the surface of the base substrate at a desired depth to produce a high-quality semiconductor substrate.

In a preferred mode of the present invention, the base substrate and the source substrate body include a SiC material. With this configuration, the present invention can provide a novel technology that enables the growth of high quality SiC semiconductor substrates.

Advantageous Effects of Invention

The disclosed technology can provide a novel technology that enables the growth of high-quality semiconductor substrates.

Other problems, features, and advantages will become apparent by reading the embodiments for implementing the present invention described below, when taken up together with the drawings and claims.

Brief Description of Drawings

Fig. 1 illustrates the method for producing a semiconductor substrate according to an embodiment of the present invention.

Fig. 2 illustrates the method for producing a semiconductor substrate according to an embodiment of the present invention.

Fig. 3 illustrates the method for producing a semiconductor substrate according to an embodiment of the present invention.

Fig. 4 illustrates the apparatus for producing a semiconductor substrate according to an embodiment of the present invention.

Fig. 5 illustrates the apparatus for producing a semiconductor substrate according to an embodiment of the present invention.

Fig. 6 illustrates the apparatus for producing a semiconductor substrate according to an embodiment of the present invention.

Fig. 7 illustrates the apparatus for producing a semiconductor substrate according to an embodiment of the present invention.

Fig. 8 illustrates the apparatus for producing a semiconductor substrate according to an embodiment of the present invention.

Fig. 9 illustrates the evaluation of the number of BPDs in Reference Example 1.

Fig. 10 is an SEM image of the substrate surface in Reference Example 2.

Fig. 11 is an SEM image of the substrate surface in Reference Example 2.

Fig. 12 illustrates the correlation between the growth rate of the semiconductor substrate and the heating temperature in Reference Example 3.

An embodiment of the present invention is described in detail below with reference to drawings. The technical scope of the present invention is not limited to the embodiments depicted in the accompanying drawings, and may be modified as necessary within the scope of the claims.

<<Method for producing semiconductor substrate>>

The following is a detailed description of the method for producing a substrate (hereinafter simply referred to as the producing method) according to an embodiment of the present invention.

The present specification describes, as an example, the case of SiC crystal growth using a SiC material, but the same effect can be achieved with semiconductor materials such as GaN (gallium nitride) and $Ga_2O_3$ (gallium oxide) materials. Therefore, the base substrate 11 and the source substrate body 12 are semiconductor materials such as SiC, GaN, and $Ga_2O_3$.

It can be understood that the present invention is a producing method including an installation step S1 of alternately installing an base substrate 11 and a source substrate body 12, a heating step S2 of heating the base substrate 11 and the source substrate body 12 to form a growth layer 111 on the base substrate 11, and a separation step S3 of separating a portion of the base substrate 11 heated by the heating step S2.

<Installation step S1>

The installation step S1 according to an embodiment of the present invention includes alternately installing the base substrate 11 and the source substrate body 12. At this time, the base substrate 11 and the source substrate body 12 are installed so that they are substantially parallel to each other. At this time, there is no limitation on the quantity of the base substrate 11 and the source substrate body 12 to be installed by the installation step S1.

In the installation step S1, the base substrate 11 and the source substrate body 12 are installed in a semi-closed space.

The "semi-closed space" in the present description refers to a space in which at least a portion of the vapor generated in the container can be confined, although the vacuation in the space is still possible.

In the installation step S1, the base substrate 11 and the source substrate body 12 are installed so that they are in close contact with each other.

As used herein, the term "close contact" refers to the proximity of different members or the like while maintaining a predetermined separation distance.

In the installation step S1, a source substrate transport prevention body 28 is installed between the unit object 1X containing the base substrate 11 and the source substrate body 12 to prevent source substrate transport between the base substrate 11 and the source substrate body 12, as described below. It can be understood that the "unit object 1X" herein includes, for example, one base substrate 11 and one source substrate body 12, and, as another example, includes a plurality of the base substrates 11 and the source substrate bodies 12. It can be understood that in the installation step S1 according to an embodiment of the present invention, one or more unit objects to be treated 1X are installed.

<Base substrate 11 and source substrate body 12>

Examples of the base substrate 11 include a SiC wafer sliced into a disk from an ingot produced by sublimation or other method, and a SiC substrate processed from SiC single crystals into a thin sheet. As for the crystal polymorphism of the SiC single crystals, any polytype may be used.

The source substrate body 12 preferably has the same material as the base substrate 11 and includes at least the atomic species that constitute the base substrate 11. Like the base substrate 11, the source substrate body 12 may be a SiC wafer sliced into a disk shape from an ingot produced by sublimation or other method, and may be a single crystal substrate or a polycrystalline substrate. The source substrate body 12 may be a processed product such as a sintered body containing SiC polycrystals.

The SiC single crystal substrate surface according to an embodiment of the present invention may be a surface having an off-angle of a few degrees (for example, from 0.4 to 8.0°) from the (0001) or (000-1) plane (in the present description, in the notation of the Miller index, "-" means the bar that immediately follows the index).

On the planarized SiC single crystal substrate surface, a step-terrace structure can be observed. The step-terrace structure is a staircase structure with alternating steps, which are steps of one or more molecular layers, and terraces, which are flat areas with the {0001} plane exposed. A single molecular layer (0.25 nm) is the minimum height (smallest unit) of a step on the planarized SiC single crystal substrate surface, and a plurality of layers of this single molecular layer overlap to form various step heights.

As used herein, bunching of steps that are so large that they exceed the height of one unit cell of each polytype is called macro-step bunching (MSB).

In other words, MSBs are the steps that are bunched more than 4 molecular layers (5 or more molecular layers) for 4H-SiC and more than 6 molecular layers (7 or more molecular layers) for 6H-SiC.

Since MSBs are one of the factors that cause defects on the surface during growth layer formation and inhibit oxide film reliability in SiC semiconductor devices, the substrate surface preferably has no MSB.

The base substrate 11 and the source substrate body 12 may be, for example, any size from a chip size of a few centimeters square to a wafer size of 6 inches or more, and there is no particular limit to their size.

The base substrate 11 has a main surface 113 (not illustrated) and a back surface 114. The source substrate body 12 has a main surface 123 and a back surface 124 (not illustrated).

As used herein, the term "surface" refers to both the main surface and the back surface. As used herein, "one side" refers to either the main surface or the back surface, and the other side refers to the same substrate surface relative to one side.

As used herein, the growth layer 111 refers to the growth layer formed on the base substrate 11 by source substrate transport.

As used herein, the growth layer 121 refers to the growth layer formed on the source substrate body 12 by source substrate transport.

The surface of the growth layer formed on the base substrate 11 preferably has an infinitely reduced basal plane dislocation (BPD) density. In the formation of the growth layer 111 and others, BPD is preferably converted to other defects and dislocations, including threading edge dislocation (TED).

<Heating step S2>

The heating step S2 includes heating the base substrate 11 and the source substrate body 12 so as to form a temperature difference between the base substrate 11 and the source substrate body 12, and crystal-growing the base substrate 11 to form the growth layer 111 on the surface of the base substrate 11.

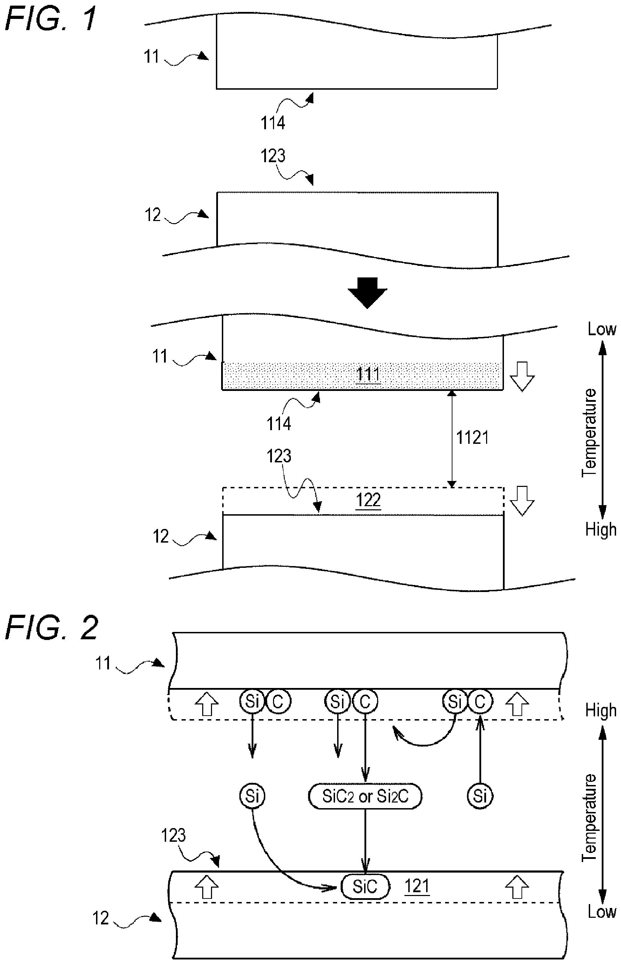

As illustrated in Fig. 1, in the heating step S2, the base substrate 11 is placed on the low temperature side, so that the formation of the growth layer 111 on the base substrate 11 (back surface 114) and the etching of the source substrate body 12 (main surface 123) are performed simultaneously.

In the heating step S2, the base substrate 11 and the source substrate body 12 are heated in a semi-closed space.

As illustrated in Fig. 2, it can be understood that the source substrate transport based on the following reactions 1) to 5) is continuously performed in the base substrate 11 and the source substrate body 12, and, for example, the growth layer 121 is formed on the source substrate body 12. The same applies to the formation of the growth layer 111 on the base substrate 11.

In an embodiment of the present invention, the base substrate 11 and the source substrate body 12 are in close contact with each other, but even in that case, it can be understood that the minute gap between the base substrate 11 and the source substrate body 12 becomes the source substrate transport space.

$$1) \quad SiC(s) \rightarrow Si(v) + C(s)$$

$$2) \quad 2C(s) + Si(v) \rightarrow SiC_2(v)$$

$$3) \quad C(s) + 2Si(v) \rightarrow Si_2C(v)$$

$$4) \quad Si(v) + SiC_2(v) \rightarrow 2SiC(s)$$

$$5) \quad Si_2C(v) \rightarrow Si(v) + SiC(s)$$

1): As the back surface 114 of the base substrate 11 is pyrolyzed, Si atoms (Si(v)) are desorbed from the back surface 114.

2) and 3): C atoms (C(s)) remaining on the back surface 114 due to desorption of Si atoms (Si(v)) react with Si vapor (Si(v)) in the source substrate transport space, and sublimate into the source substrate transport space as, for example, $Si_2C$ or $SiC_2$.

4) and 5): The sublimed $Si_2C$, $SiC_2$, or the like reaches and diffuses into the terraces on the main surface 123 of the source substrate body 12 due to the temperature gradient, and by reaching the steps, the growth layer 121 is grown and formed by taking over the polymorphism of the main surface 123 (step-flow growth).

The heating step S2 includes a Si atom sublimation step S21 of thermally sublimating Si atoms from the surface of the base substrate 11 or the source substrate body 12, and a C atom sublimation step S22 of sublimating C atoms remaining on the surface of the base substrate 11 or the source substrate body 12 by bonding them with Si atoms in the source substrate transport space.

The heating step S2 includes an etching step S23 of etching the surface of the base substrate 11 or the source substrate body 12 based on the Si atom sublimation step S21 and C atom sublimation step S22. The heating step S2 includes, for example, a growth step S24 of etching the surface of the source substrate body 12, and forming the growth layer 111 on the surface of the base substrate 11 based on the aforementioned step-flow growth. The steps included in the heating step S2 are performed sequentially. It can be understood that the growth step S24 is based on physical vapor transport (PVT) because the transported $Si_2C$, $SiC_2$, or the like becomes supersaturated and condenses to form the growth layer 111.

It can be understood that the heating step S2 includes a bunching decomposition step of decomposing the MSBs on the SiC single crystal substrate surface.

It can be understood that the driving force for source substrate transport in the heating step S2 is the vapor pressure difference between the base substrate 11 and the source substrate body 12 due to the temperature gradient formed. Therefore, it can be understood that not only the temperature difference between the surfaces of the base substrate 11 and the source substrate body 12, but also the vapor pressure difference and chemical potential difference caused by the crystal structure between the base substrate 11 and the source substrate body 12 can be the driving force for the source substrate transport.

In the heating step S2, when the base substrate 11, the source substrate body 12, the source substrate transport prevention body 28, the base substrate 11, and the source substrate body 12 are stacked in this order, it can be understood that the growth layer 111 is formed only on the main surface or the back surface of the base substrate 11.

The SiC material as a portion of the apparatus that forms the semi-closed space in the heating step S2 can be the source substrate body 12 as appropriate.

In the source substrate transport in the heating step S2, the doping concentration in the growth layer 111 can be adjusted by supplying a dopant gas into the semi-closed space by a dopant gas supply means. When no dopant gas is supplied into the semi-closed space by the dopant gas supply means, it can be understood that the growth layer 111 takes over the doping concentration in the semi-closed space.

The source substrate transport in the heating step S2 is performed preferably under an environment with a gas phase species containing Si elements and a gas phase species containing C element, more preferably in a SiC-Si equilibrium vapor pressure environment, and even more preferably in a SiC-C equilibrium vapor pressure environment.

As used herein, the term "SiC-Si vapor pressure environment" refers to the vapor pressure environment when SiC (solid) and Si (liquid phase) are in phase equilibrium through a vapor phase.

As used herein, the term "SiC-C equilibrium vapor pressure environment" refers to the environment of vapor pressure when SiC (solid phase) and C (solid phase) are in phase equilibrium through a vapor phase.

The SiC-Si equilibrium vapor pressure environment is formed by heating a semi-closed space having an atomic number ratio Si/C of more than 1.

The SiC-C equilibrium vapor pressure environment is formed by heating a semi-closed space having an atomic number ratio Si/C of 1 or less.

The heating temperature in the heating step S2 is preferably set in the range of from 1400 to 2300°C, and more preferably from 1600 to 2000°C.

The heating time in the heating step S2 may be set to any desired amount of time to achieve the desired etching amount.

For example, when the etching rate is 1.0 $\mu$m/min and the etching amount is to be 1.0 $\mu$m, the heating time is 1 minute.

The temperature gradient in the heating step S2 is, for example, set in the range of from 0.1 to 5.0°C/mm, and is preferably uniform in the source substrate transport space.

The etching amount and the growth amount in the heating step S2 are, for example, in the range of from 0.1 to 20 $\mu$m, and may be changed as appropriate. It can be understood that the etching amount and the growth amount are equivalent.

The etching rate and the growth rate of the growth layer 111 in the heating step S2 may be controlled in the aforementioned temperature range, for example, in the range of from 0.001 to 2.0 $\mu$m/min.

It can be understood that the surface layer on the SiC single crystal substrate to be etched in the heating step S2 is, for example, a damaged layer 300 having scratches, latent scratches, and strains that have been introduced through mechanical processing (for example, slicing, grinding or polishing) or laser processing.

<Separation step S3>

In the separation step S3, examples of the method for separating a substrate 13 include multi-wire saw cutting, which cuts by reciprocating a plurality of wires, the EDM method, which cuts by intermittent plasma discharge, and a method of cutting using laser light that irradiates and focuses laser light into crystals to form a layer that serves as the base point for cutting. In the separation step S3, when a cutting technique using laser light is used, the loss of material in the separation of the 13 substrates can be reduced.

The separation step S3 includes separating a portion of the base substrate 11 having the growth layer 111 to obtain the substrate 13 having the growth layer 111.

The separation step S3 includes at least an introduction step S31 of introducing the damaged layer 300 to the base substrate 11, and a peeling step S32 of peeling off the substrate 13 using the damaged layer 300 as a starting point.

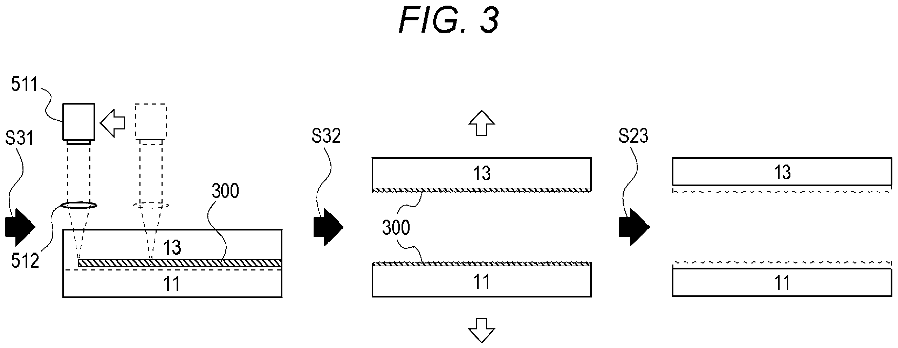

As illustrated in Fig. 3, in the introduction step S31, the light collecting point of the laser light of a wavelength that is transmissive to the base substrate 11 is positioned inside the base substrate 11 at a depth corresponding to the thickness of the substrate 13 to be separated from the top surface, and laser light is irradiated to the base substrate 11 to form the damaged layer 300.

As illustrated in Fig. 3, the peeling step S32 includes peeling off the substrate 13 having the growth layer 111 from the base substrate 11 along the damaged layer 300. The peeling step S32 includes, for example, separating the surface and the back surface of the base substrate 11 by adsorbing them to a pedestal or the like. In the peeling step S32, the substrate 13 is peeled off from the base substrate 11 starting from the damaged layer 300 by applying customary mechanical vibration to the base substrate 11 by reciprocating a thin wire along the damaged layer 300 or by generating ultrasonic vibration.

In the introduction step S31 and the peeling step S32, at least some of the known technologies, such as the methods described in, for example, JP 2013-49161 A, JP 2018-207034 A, JP 2017-500725 A, and JP 2017-526161 A, may be used as appropriate.

In addition, in the introduction step S31 and the peeling step S32, at least some of the known technologies such as the methods described in patent literatures such as, for example, JP 2017-526161 A, JP 2017-500725 A, JP 2018-152582 A, JP 2019-500220 A, and JP 2019-511122 A may be used as appropriate.

As described above, the substrate 13 having the growth layer 111 is produced by having the base substrate 11 undergo the installation step S1, the heating step S2, and the separation step S3. By repeating this series of steps, the substrate 13 having the growth layer 111 can be repeatedly produced. The series of steps can be performed again using the produced substrate 13 having the growth layer 111 as the base substrate 11.

Each of the base substrate 11 and the substrate 13 obtained through the installation step S1, the heating step S2, and the separation step S3 has the residual damaged layer 300. Therefore, an embodiment of the present invention may be configured to remove the remaining damaged layer 300 from the base substrate 11 and the substrate 13 by subjecting the base substrate 11 and substrate 13 after the separation step S3 to the heating step S2 including the etching step S23.

In an embodiment of the present invention, the installation step S1, the heating step S2, an installation step S1a, a heating step S2a, and the separation step S3 may be performed in this order. The installation step S1a includes installing the base substrate 11 and the source substrate body 12 along the thickness direction of the base substrate 11 and the source substrate body 12 so as to reverse the order of installation of the base substrate 11 and the source substrate body 12 that have been installed in the installation step S1. The heating step S2a includes heating the base substrate 11 and the source substrate body 12 in the same manner as in the heating step S2.

In an embodiment of the present invention, the installation step S1, the heating step S2, the heating step S2a, and the separation step S3 may be performed in this order. A heating step S2b includes heating the base substrate 11 and the source substrate body 12 so as to reverse the temperature gradient formed along the thickness direction of the base substrate 11 and the source substrate body 12. In the heating step S2b, the base substrate 11 and the source substrate body 12 are heated under the same temperature conditions and atmosphere as in the heating step S2, based on the source substrate transport mechanism.

<<Apparatus for producing semiconductor substrate>>

The following is a detailed description of the apparatus for producing a semiconductor substrate (hereinafter simply referred to as the producing apparatus) according to an embodiment of the present invention. Components that are basically the same as those described in the previous producing method are marked with the same reference numerals to simplify their description.

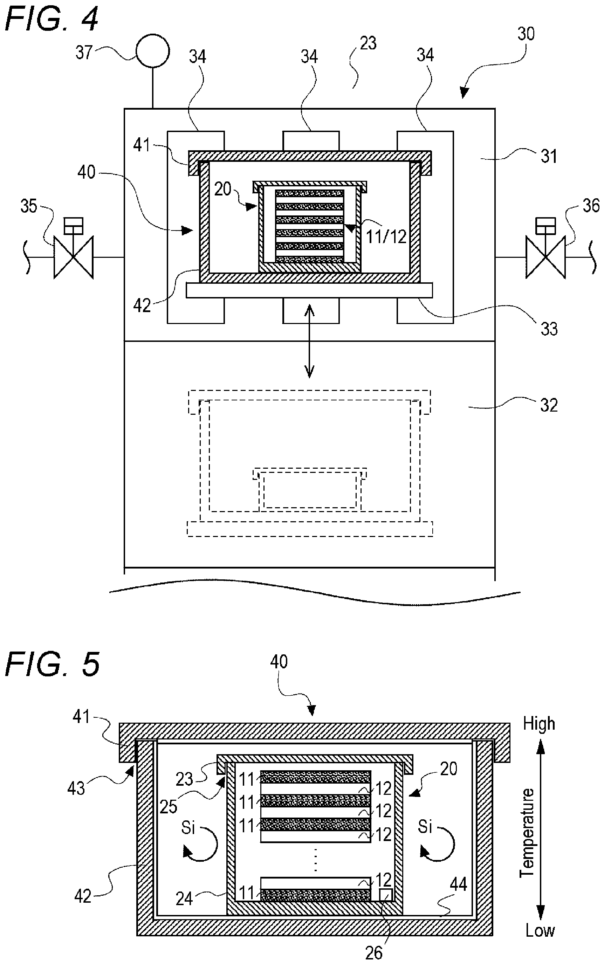

As illustrated in Fig. 4, the producing apparatus includes a main container 20, a heating furnace 30, a refractory material container 40, and a separation means 50.

It can be understood that the base substrate 11 and the source substrate body 12 are alternately installed so that the base substrate 11 and the source substrate body 12 form a predetermined separation distance 1112.

The separation distance 1112 is preferably 10 mm or less, more preferably 7.0 mm or less, even more preferably 5.0 mm or less, yet even more preferably 4.0 mm or less, yet even more preferably 3.0 mm or less, yet even more preferably 2.0 mm or less, yet even more preferably 1.7 mm or less, yet even more preferably 1.5 mm or less, yet even more preferably 1.2 mm or less, yet even more preferably 1.0 mm or less, yet even more preferably 700 $\mu$m or less, yet even more preferably 500 $\mu$m or less, yet even more preferably 200 $\mu$m or less, yet even more preferably 100 $\mu$m or less, yet even more preferably 70 $\mu$m or less, yet even more preferably 50 $\mu$m or less, yet even more preferably 20 $\mu$m or less, yet even more preferably 10 $\mu$m or less, yet even more preferably 7.0 $\mu$m or less, yet even more preferably 5.0 $\mu$m or less, yet even more preferably 2.0 $\mu$m or less, yet even more preferably 1.0 $\mu$m or less, yet even more preferably 0.7 $\mu$m or less, yet even more preferably 0.5 $\mu$m or less, and yet even more preferably 0.2 $\mu$m or less.

The separation distance 1112 is preferably 0.1 $\mu$m or more, more preferably 0.2 $\mu$m or more, even more preferably 0.5 $\mu$m or more, yet even more preferably 0.7 $\mu$m or more, yet even more preferably 1.0 $\mu$m or more, yet even more preferably 2.0 $\mu$m or more, yet even more preferably 5.0 $\mu$m or more, yet even more preferably 7.0 $\mu$m or more, yet even more preferably 10 $\mu$m or more, yet even more preferably 20 $\mu$m or more, yet even more preferably 50 $\mu$m or more, yet even more preferably 70 $\mu$m or more, yet even more preferably 100 $\mu$m or more, yet even more preferably 200 $\mu$m or more, yet even more preferably 500 $\mu$m or more, yet even more preferably 700 $\mu$m or more, yet even more preferably 1.0 mm or more, yet even more preferably 1.2 mm or more, yet even more preferably 1.5 mm or more, yet even more preferably 1.7 mm or more, yet even more preferably 2.0 mm or more, yet even more preferably 3.0 mm or more, yet even more preferably 4.0 mm or more, yet even more preferably 5.0 mm or more, and yet even more preferably 7.0 mm or more.

The main container 20 may include a customary distance adjustment means 27 such as a spacer to adjust the separation distance 1112. The distance adjustment means 27 includes the same atomic species as the base substrate 11 and the source substrate body 12.

<Main container 20>

As illustrated in Fig. 5, the main container 20 is a container in which the base substrate 11 and the source substrate body 12 can be alternately installed. At this time, the base substrate 11 and the source substrate body 12 are placed so that they are in close contact with each other. At this time, the main container 20 has a semi-closed space inside. When the main container 20 is heated, it generates a vapor pressure of the vapor phase species including the atomic species that constitute the base substrate 11 inside the container. At this time, there is no limitation on the quantity of each of the base substrate 11 and the source substrate body 12 installed in the main container 20. The base substrate 11 and the source substrate body 12 may be alternately installed in the order of the base substrate 11, the source substrate body 12, and the base substrate 11, or in the order of the source substrate body 12, the base substrate 11, and the source substrate body 12.

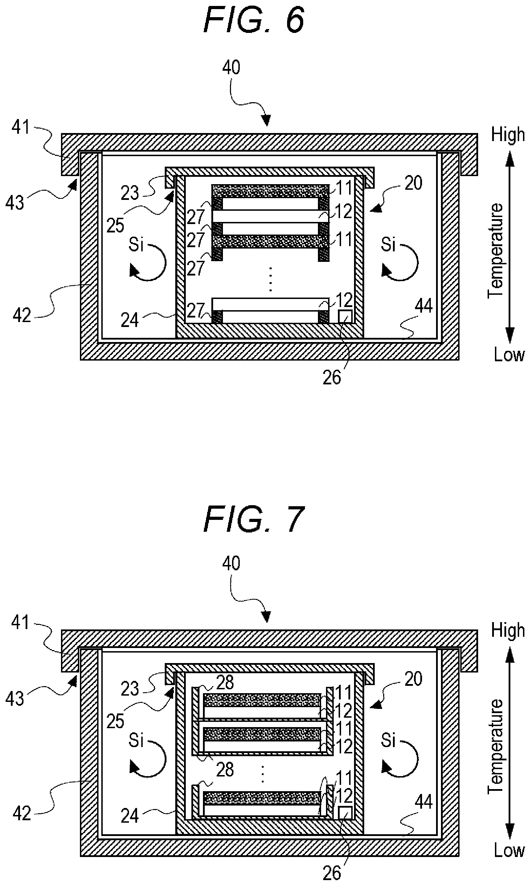

As illustrated in Fig. 6, the main container 20 is a container in which the base substrate 11 and the source substrate body 12 can be alternately installed. At this time, the base substrate 11 and the source substrate body 12 are alternately installed so that they are separated from each other by the distance adjustment means 27 by the separation distance 1112. The base substrate 11 and the source substrate body 12 may be alternately installed in the order of the base substrate 11, the source substrate body 12, and the base substrate 11, or in the order of the source substrate body 12, the base substrate 11, and the source substrate body 12.

The main container 20 has a semi-closed space inside. When the main container 20 is heated, it generates a vapor pressure of the gas phase species containing the atomic species that constitute the base substrate 11 inside the container. At this time, there is no limitation on the quantity of each of the base substrate 11 and the source substrate body 12 installed in the main container 20.

As illustrated in Fig. 7, in the main container 20, the source substrate transport prevention body 28, which prevents source substrate transport between the base substrate 11 and the source substrate body 12 between different unit objects 1X, can be installed between the unit objects 1X including the base substrate 11 and the source substrate body 12. At this time, there is no limitation on the quantity of each of the unit object 1X and the source substrate transport prevention body 28 installed in the main container 20. The base substrate 11 and the source substrate body 12 may be alternately installed in the order of the base substrate 11, the source substrate body 12, and the base substrate 11, or in the order of the source substrate body 12, the base substrate 11, and the source substrate body 12.

The source substrate transport prevention body 28 is preferably a high-melting point metal such as W, Re, Os, Ta, or Mo, a carbide such as $Ta_9C_8$, HfC, TaC, NbC, ZrC, $Ta_2C$, TiC, WC, or MoC, or a boride such as $HfB_2$, $TaB_2$, $ZrB_2$, $NB_2$, or $TiB_2$ that does not become a transport destination or source in the aforementioned source substrate transport between the base substrate 11 and the source substrate body 12.

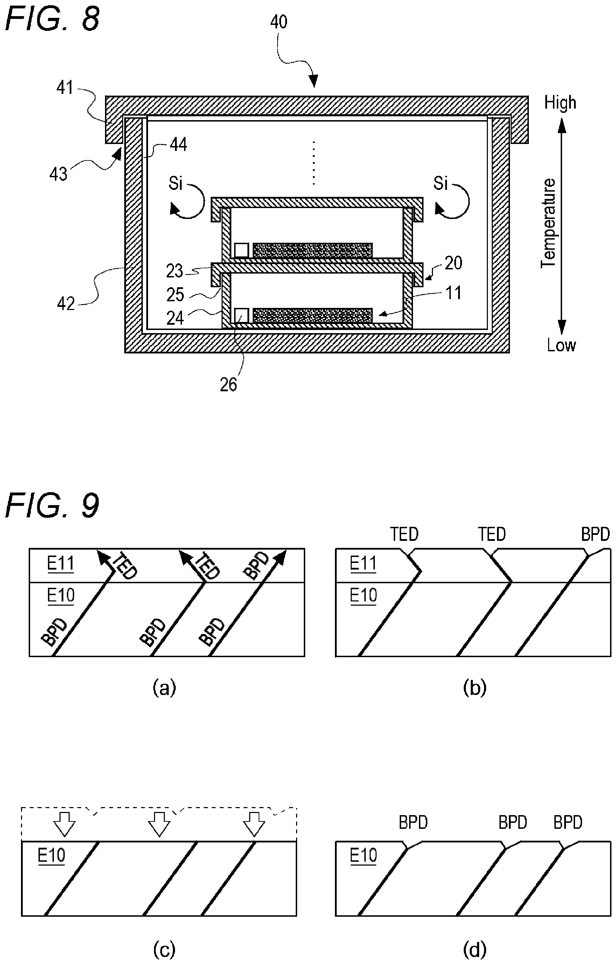

As illustrated in Fig. 8, each of the plurality of main containers 20 houses one base substrate 11. At this time, each of the plurality of main containers 20 can be fitted to each other. At this time, the main container 20 has a semi-closed space inside. When the main container 20 is heated, it generates a vapor pressure of the gas phase species containing the atomic species that constitute the base substrate 11 inside the container. At this time, there is no limitation on the quantity of the main containers 20 that house one base substrate 11. Each of the plurality of main containers 20 may be configured to house the base substrate 11 and the source substrate body 12.

The main container 20 includes, for example, a SiC material containing SiC polycrystals. Therefore, at least a portion of the main container 20 can be the destination or source of transport in the source substrate transport as the source substrate body 12.

In an embodiment of the present invention, at least a portion of the configurations in Figs. 5 to 8 may be combined as appropriate to realize a main container in which at least the base substrate 11 and the source substrate body 12 can be alternately installed.

The environment in the heated main container 20 is preferably, for example, a vapor pressure environment of a mixed system of a gas phase species containing Si elements and a gas phase species containing C element. Examples of the gas phase species containing Si elements include Si, $Si_2$, $Si_3$, $Si_2C$, $SiC_2$, and SiC. Examples of the gas phase species containing C elements include $Si_2C$, $SiC_2$, SiC, and C.

The dopant and doping concentration of the main container 20 may be selected according to the dopant and doping concentration of the growth layer 111 or 121 to be formed. Examples of the dopant include N elements.

Any structure that generates vapor pressure of a gas phase species containing Si elements and a gas phase species containing C elements in the internal space during the heating treatment of the main container 20 may be used. Examples of the structure include a configuration in which the SiC polycrystals are partially exposed on the inner surface, and a configuration in which the SiC polycrystals are separately installed in the main container 20.

The main container 20 is, for example, a fitting container including an upper container 23 and a lower container 24 that can be fitted to each other. A minute gap 25 is formed at the fitting part of the upper container 23 and the lower container 24, through which the inside of the main container 20 can be evacuated (vacuated).

<Si-vapor supply source 26>

The main container 20 includes a Si-vapor supply source 26 (not illustrated in Fig. 4 but illustrated in Fig. 5).

The Si-vapor supply source 26 is used to adjust the atomic number ratio Si/C of the semi-closed space in the main container 20 to be more than 1. Examples of the Si-vapor supply source include solid Si (Si pellet such as Si pieces or Si powder) and Si compounds.

For example, when the entire main container 20 includes SiC polycrystals, as in an embodiment of the present invention, the atomic number ratio Si/C in the main container 20 exceeds 1 by installing a Si-vapor supply source 26. Specifically, when the base substrate 11 and the source substrate body 12, which satisfy the stoichiometric ratio of 1:1, and the Si-vapor supply source 26 are installed in the SiC polycrystalline main container 20 that satisfies the stoichiometric ratio of 1:1, the atomic number ratio Si/C in the main container 20 will exceed 1.

The SiC-Si equilibrium vapor pressure environment according to an embodiment of the present invention is formed by heating a semi-closed space having an atomic number ratio Si/C of more than 1. The SiC-C equilibrium vapor pressure environment according to an embodiment of the present invention is formed by heating a semi-closed space having an atomic number ratio Si/C of 1 or less. The main container 20 according to an embodiment of the present invention may be configured to house predetermined members as appropriate so as to achieve a SiC-Si equilibrium vapor pressure environment or SiC-C equilibrium vapor pressure environment.

<Heating furnace 30>

The heating furnace 30 is configured to heat the main container 20 to form a temperature gradient so that the temperature decreases/increases from the upper container 23 to the lower container 24. This creates a temperature gradient in the direction of the thickness of the base substrate 11.

As illustrated in Fig. 4, the heating furnace 30 includes a main heating chamber 31 capable of heating the object to be treated (for example, the base substrate 11, the main container 20, and the refractory material container 40) to a temperature of from 1000°C to 2300°C, a preliminary chamber 32 capable of preheating the object to be treated to a temperature of 500°C or higher, a refractory material container 40 capable of housing the main container 20, and a moving means 33 (moving table) capable of moving the refractory material container 40 from the preliminary chamber 32 to the main heating chamber 31.

The main heating chamber 31 is regular hexagonal in planar cross-sectional view, and the refractory material container 40 is installed inside it. The main heating chamber 31 includes heaters 34 (mesh heaters). Multilayer heat-reflective metal plates are fixed to the side walls and ceiling of the main heating chamber 31 (not illustrated.). The multilayer heat-reflective metal plates are configured to reflect the heat of the heaters 34 toward the substantially central portion of the main heating chamber 31.

The heaters 34 are installed in the main heating chamber 31 to surround the refractory material container 40 in which the object to be treated is contained. At this time, the multilayer heat-reflective metal plates are installed on the outside of the heaters 34, which enables temperature increase in the temperature range of from 1000°C to 2300°C.

The heaters 34 may be, for example, or resistance heating type or high-frequency induction heating type.

The heaters 34 may be configured to form a temperature gradient in the refractory material container 40.

For example, the heaters 34 may be configured so that more heaters are installed on the upper (or lower) side. The heaters 34 may be configured so that the width increases toward the upper (or lower) side. Alternatively, the heaters 34 may be configured to be able to increase the power supplied toward the upper (or lower) side. The heaters 34 may be capable of reversing the direction of the temperature gradient formation.

The main heating chamber 31 is connected to a vacuum formation valve 35 for evacuating air from the main heating chamber 31, an inert gas injection valve 36 for introducing an inert gas into the main heating chamber 31, and a vacuum gauge 37 for measuring the degree of vacuum in the main heating chamber 31.

The vacuum formation valve 35 is connected to a vacuum pump (not illustrated) that evacuates air and vacuates the main heating chamber 31. By using the vacuum formation valve 35 and the vacuum pump, the degree of vacuum in the main heating chamber 31 can be adjusted preferably to 10 Pa or less, more preferably to 1.0 Pa or less, and most preferably to $10^{-3}$ Pa or less. Examples of the vacuum pump include a turbo molecular pump.

The inert gas injection valve 36 is connected to an inert gas supply source (not illustrated). This inert gas injection valve 36 and the inert gas supply source allow inert gas to be introduced into the main heating chamber 31 in the range of from $10^{-5}$ to $10^4$ Pa. The inert gas may be, for example, Ar.

The inert gas injection valve 36 is a dopant gas supply means that can supply a dopant gas into the main container 20. That is, by selecting a dopant gas (for example, $N_2$) as the inert gas, the doping concentration in the growth layer 111 can be increased.

The preliminary chamber 32 is connected to the main heating chamber 31, and is configured to allow the refractory material container 40 to be moved by the moving means 33. The preliminary chamber 32 of the present embodiment is configured to be heated by the residual heat of the heater 34 of the main heating chamber 31. For example, when the main heating chamber 31 is heated to 2000°C, the preliminary chamber 32 is heated to about 1000°C, which allows the degassing treatment of the object to be treated.

The moving means 33 is configured to place the refractory material container 40 and move it between the main heating chamber 31 and the preliminary chamber 32.

The transfer between the main heating chamber 31 and the preliminary chamber 32 by the moving means 33 can be completed in as little as one minute, so that temperature rise and fall at from 1.0 to 1000°C/min can be achieved. This allows for rapid temperature rise and fall, which makes it possible to observe the surface profile without low temperature growth history during temperature rise and fall. In Fig. 4, the preliminary chamber 32 is located below the main heating chamber 31, but the preliminary chamber 32 may be installed in any other direction.

The moving means 33 according to the present embodiment is a moving table on which the refractory material container 40 is placed. The contact area between the moving table and the refractory material container 40 becomes the path for heat propagation. This makes it possible to form a temperature gradient in the refractory material container 40 so that the contact area between the moving table and the refractory material container 40 is on the low temperature side.

In the heating furnace 30 of the present embodiment, since the bottom of the refractory material container 40 is in contact with the moving table, a temperature gradient is provided so that the temperature decreases from the upper container 41 to the lower container 42 of the refractory material container 40.

The direction of the temperature gradient can be set in any direction by changing the position of the contact area between the moving table and the refractory material container 40. For example, when a suspended type or the like is used for the moving table and the contact area is set on the ceiling of the refractory material container 40, heat escapes in the upward direction. Therefore, a temperature gradient is provided so that the temperature increases from the upper container 41 to the lower container 42 of the refractory material container 40. This temperature gradient is preferably formed along the thickness direction of the base substrate 11 and the source substrate body 12. The temperature gradient may be formed by the configuration of the heater 34 as described above.

<Refractory material container 40>

The vapor pressure environment of the gas-phase species containing Si elements in the heating furnace 30 according to the present embodiment is formed using the refractory material container 40 and a Si-vapor supply material 44. For example, any method that enables the formation of an environment of vapor pressure of a gas phase species containing Si elements around the main container 20 may be used in the apparatus for producing a semiconductor substrate of the present invention.

The refractory material container 40 preferably includes a high-melting point material having a melting point equal to or higher than the melting point of the material constituting the main container 20.

Examples of the refractory material container 40 include C which is a general-purpose heat-resistant material, W, Re, Os, Ta, and Mo which are high-melting point metals, $Ta_9C_8$, HfC, TaC, NbC, ZrC, $Ta_2C$, TiC, WC, and MoC which are carbides, HfN, TaN, BN, $Ta_2N$, ZrN, and TiN which are nitrides, $HfB_2$, $TaB_2$, $ZrB_2$, $NB_2$, and $TiB_2$ which are borides, and SiC polycrystals.

As illustrated in Fig. 5, the refractory material container 40, like the main container 20, is a fitting container including the upper container 41 and the lower container 42 that can be fitted to each other, and is configured to house the main container 20. A minute gap 43 is formed at the fitting portion between the upper container 41 and the lower container 42, through which the inside of the refractory material container 40 can be evacuated (vacuated).

The refractory material container 40 has the Si-vapor supply material 44 that can supply vapor pressure of gas phase species containing Si elements in the refractory material container 40.

<Si-vapor supply material 44>

The Si-vapor supply material 44 should be configured to generate Si vapor in the refractory material container 40 during the heat treatment, and examples thereof include solid Si (Si pellets such as Si pieces and Si powder) and Si compounds.

The Si-vapor supply material 44 is, for example, a thin film that coats the inner wall of the refractory material container 40.

When the refractory material container 40 is a metal compound such as TaC, the Si-vapor supply material 44 is, for example, a silicide material of the metal and Si atoms constituting the refractory material container 40.

<Separation means>

The separation means 50 separates a portion of the base substrate 11 with the growth layer 111 to obtain the substrate 13 having the growth layer 111.

The separation means 50 includes at least an introduction means 51, in which the damaged layer 300 is introduced to the base substrate 11, and a peeling means 52 for peeling off the substrate 13 using the damaged layer 300 as a starting point.

As illustrated in Fig. 3, the introduction means 51 positions the light collecting point of the laser light of a wavelength, which is transmissive to the growth layer 111 and the base substrate 11, inside the base substrate 11 at a depth corresponding to the thickness of the substrate 13 to be separated from the top surface, and irradiates laser light to the base substrate 11 to form the damaged layer 300.

The introduction means 51 includes, for example, a holding means (not illustrated) capable of holding the base substrate 11 and the source substrate body 12 based on a conventional method such as an absorption chuck, an oscillation means 511 that is a light source capable of irradiating pulse oscillating laser light, and a customary light collecting means 512 such as a lens capable of focusing the laser light, and is capable of scanning at least a portion of the oscillation means 511 and the light collecting means 512.

In the introduction means 51, at least a portion of the devices constituting the introduction means 51 has a customary adjustment means that can be aligned in any axial direction. There are no limitation on the wavelength, time width, output power, or spot diameter of the laser light.

As illustrated in Fig. 3, the peeling means 52 peels off the substrate 13 having the growth layer 111 from the base substrate 11 along the damaged layer 300.

The peeling means 52 is, for example, a method of separating the surface and the back surface of the base substrate 11 by adsorbing them to a pedestal or the like.

In addition, the peeling means 52 peels off the substrate 13 from the base substrate 11 starting from the damaged layer 300 by applying customary mechanical vibration to the base substrate 11 by reciprocating a thin wire along the damaged layer 300 or by generating ultrasonic vibration.

The peeling means 52 has a refractory material container for peeling that can house the base substrate 11, and a holding means that can hold the base substrate 11 based on a customary method such as an adsorption chuck.

The peeling means 52 includes a vibration means capable of generating customary mechanical vibrations, including ultrasonic vibrations, and providing the mechanical vibrations to the base substrate 11, and a liquid supply means capable of supplying a liquid such as pure water based on a customary method.

The introduction means 51 and the peeling means 52 may use, for example, devices for realizing known technologies as appropriate.

Each of the introduction means 51 and the peeling means 52 may employ at least some of the devices described in, for example, JP 2013-49161 A, JP 2018-207034 A, JP 2017-500725 A, and JP 2017-526161 A as appropriate.

In addition, each of the introduction means 51 and the peeling means 52 may employ at least some of the devices described in patent literatures such as, for example, JP 2017-526161 A, JP 2017-500725 A, JP 2018-152582 A, JP 2019-500220 A, and JP 2019-511122 A as appropriate.

As described above, the substrate 13 having the growth layer 111 is produced by treating the base substrate 11 with the main container 20, the heating furnace 30, and the separation means 50. By repeating this treatment, the substrate 13 having the growth layer 111 may be repeatedly produced. In addition, the treatment may be performed using the substrate 13 having the growth layer 111 as a new base substrate 11.

The present description describes the effects of the present invention with reference to Reference Examples 1 to 3.

<<Reference Example 1>>

Under the following conditions, the SiC single crystal substrate E10 is housed in the main container 20, and the main container 20 is housed in the refractory material container 40.

<SiC single crystal substrate E10>

Polymorphism: 4H-SiC
Substrate size: horizontal width (10 mm), vertical width (10 mm), thickness (0.3 mm)
Off-direction and off-angle: 4° off in <11-20> direction
Growth surface: (0001) plane
Presence or absence of MSB: absent
Damaged layer: absent

<Main container>

Material: SiC polycrystals
Container size: diameter (60 mm), height (4.0 mm)
Distance between SiC single crystal substrate E10 and SiC material: 2.0 mm
Atomic number ratio Si/C in the container: 1 or less

<Refractory material container>

Material: TaC
Container size: diameter (160 mm), height (60 mm)
Si-vapor supply material 44 (Si compound): $TaSi_2$

The SiC single crystal substrate E10 installed under the above conditions is heat-treated under the following conditions.

Heating temperature: 1700°C
Heating time: 300 min
Temperature gradient: 1.0°C/mm
Growth rate: 5.0 nm/min
Degree of vacuum of main heating chamber 31: $10^{-5}$ Pa

Fig. 9 illustrates the method for determining the conversion rate from BPDs to other defects and dislocations (for example, TED) in the growth layer E11.

Fig. 9(a) illustrates the growth of the growth layer E11 by the heating step. During this heating step, the BPDs present on the SiC single crystal substrate E10 are converted to TEDs with a certain probability. Therefore, TEDs and BPDs are mixed on the surface of the growth layer E11, unless the BPDs are 100% converted.

Fig. 9(b) illustrates the confirmation of detects in the growth layer E11 using the KOH dissolution etching method. In the KOH dissolution etching method, the SiC single crystal substrate E10 is immersed in a dissolved salt (for example, KOH) that has been heated to about 500°C, etch pits are formed in the dislocation or defect region, and the type of dislocation is determined by the size and shape of the etch pits. By this method, the number of BPDs present on the surface of the growth layer E11 is evaluated.

Fig. 9(c) illustrates the removal of the growth layer E11 after KOH dissolution etching.

In this method, after planarization by mechanical polishing or CMP to the depth of the etch pit, the growth layer E11 is removed by thermal etching to reveal the surface of the SiC single crystal substrate E10.

Fig. 9(d) illustrates the confirmation of defects in the SiC single crystal substrate E10 after removal of the growth layer E11 from the SiC single crystal substrate E10 using the KOH dissolution etching method. By this method, the number of BPDs present on the surface of SiC single crystal substrate E10 is evaluated.

By comparing the number of BPDs in the surface of the growth layer E11 (see Fig. 9(b)) with the number of BPDs in the surface of the SiC single crystal substrate E10 (see Fig. 9(d)), according to the sequence illustrated in Fig. 9, the BPD conversion rate, which is the conversion of BPDs to other defects and dislocations during the heating step S2, can be obtained.

The number of BPDs in the surface of the growth layer E11 in Reference Example 1 was about $0/cm^{-2}$, and the number of BPDs in the surface of the SiC single crystal substrate E10 was $1000/cm^{-2}$. Therefore, it can be understood that BPDs are reduced and removed by placing and heating the SiC single crystal substrate E10 without MSBs on the surface in a semi-closed space having an atomic number ratio Si/C of 1 or less.

In Reference Example 1, a SiC-C equilibrium vapor pressure environment is formed in the main container 20 so that the atomic number ratio Si/C in the main container 20 is 1 or less. It can be understood that since the heating step S2 including the etching step S23 in the aforementioned method and the heating step S2 including the etching step according an embodiment of the present invention are based on the same elementary reaction step, BPDs can be reduced and removed in the etching step according to an embodiment of the present invention.

<<Reference Example 2>>

Under the following conditions, the SiC single crystal substrate E10 was housed in the main container 20, and the main container 20 was further housed in the refractory material container 40.

<SiC single crystal substrate E10>

Polymorphism: 4H-SiC
Substrate size: horizontal width (10 mm), vertical width (10 mm), thickness (0.3 mm)
Off-direction and off-angle: 4° off in <11-20> direction
Growth surface: (0001) plane
Presence or absence of MSB: present

<Main container>

Material: SiC polycrystals
Container size: diameter (60 mm), height (4.0 mm)
Distance between SiC single crystal substrate E10 and SiC material: 2.0 mm
Si-vapor supply source 26: Si piece
Atomic number ratio Si/C in the container: more than 1

By housing Si pieces together with a SiC single crystal substrate in the main container 20, the atomic number ratio Si/C in the container exceeds 1.

<Refractory material container>

Material: TaC
Container size: 160 mm (diameter) × 60 mm (height)
Si-vapor supply material 44 (Si compound): $TaSi_2$

The SiC single crystal substrate E10 installed under the above conditions is heat-treated under the following conditions.

Heating temperature: 1800°C
Heating time: 60 min
Temperature gradient: 1.0°C/mm
Growth rate: 68 nm/min
Degree of vacuum of main heating chamber 31: $10^{-5}$ Pa

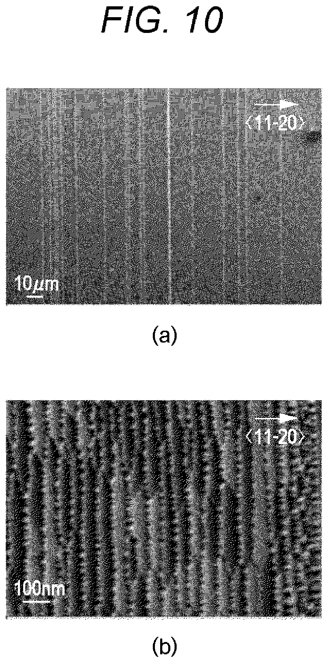

Fig. 10 is an SEM image of the surface of SiC single crystal substrate E10 before the growth of the growth layer E11. Fig. 10(a) is a SEM image observed at a magnification of ×1000, and Fig. 10(b) is a SEM image observed at a magnification of ×100000. The MSBs are formed on the surface of SiC single crystal substrate E10 before the growth of the growth layer E11, and it can be understood that the steps having a height of 3.0 nm or more are arranged with an average terrace width of 42 nm. The step height was measured by AFM.

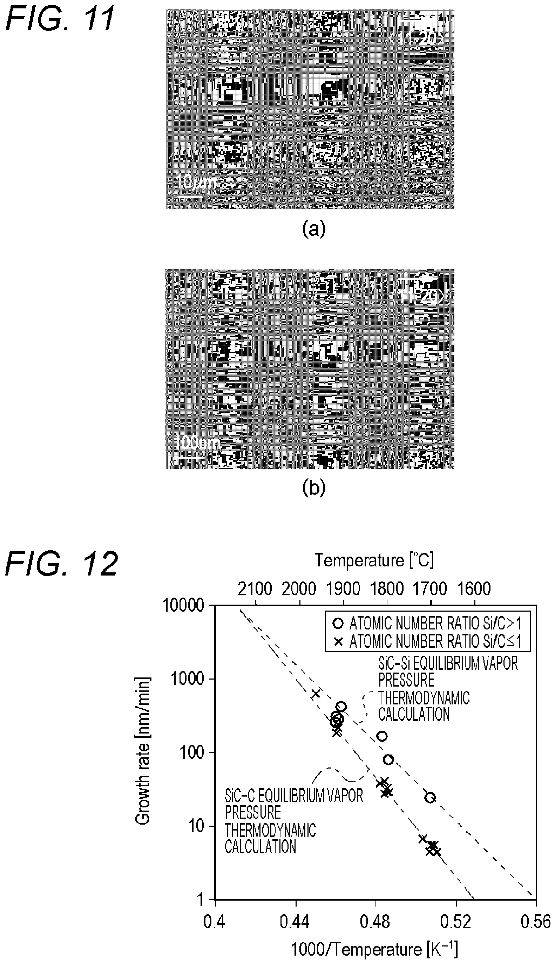

Fig. 11 is an SEM image of the surface of the SiC single crystal substrate E10 after the growth of the growth layer E11. Fig. 11(a) is a SEM image observed at a magnification of ×1000, and Fig. 11(b) is a SEM image observed at a magnification of ×100000.

No MSBs are formed on the surface of the growth layer E11 of Reference Example 2, and it can be understood that the steps having a height of 1.0 nm (full unit cell) are regularly arranged with a terrace width of 14 nm. The step height was measured by AFM.

Therefore, it can be understood that the SiC single crystal substrate E10 having MSBs on the surface is placed in a semi-closed space having an atomic number ratio Si/C of more than 1, and heated to form the growth layer E11 in which the MSBs are decomposed.

In Reference Example 2, a SiC-Si equilibrium vapor pressure environment is formed in the main container 20 because the Si-vapor supply source 26 is installed so that the atomic number ratio Si/C in the main container 20 exceeds 1.

It can be understood that since the heating step S2 including the etching step S23 in the aforementioned method and the heating step including the etching step according an embodiment of the present invention are based on the same elementary reaction step, MSBs on the SiC single crystal substrate surface can be decomposed in the etching step according to an embodiment of the present invention.

<<Reference Example 3>>

Fig. 12 is a graph of the relationship between the heating temperature and the growth rate in the method for producing a SiC single crystal substrate of the present invention. The horizontal axis of this graph is the reciprocal of the temperature, and the vertical axis of this graph is the logarithmic growth rate. The results of growing the growth layer E11 on the SiC single crystal substrate E10 by placing the SiC single crystal substrate E10 in a space (in the main container 20) having an atomic number ratio Si/C of more than 1 are marked with o. The results of growing the growth layer E11 on the SiC single crystal substrate E10 by placing it in a space (in the main container 20) having an atomic number ratio Si/C of 1 or less are marked with x.

In the graph in Fig. 12, the results of thermodynamic calculations for SiC substrate growth in a SiC-Si equilibrium vapor pressure environment are depicted as dashed lines (Arrhenius plot), and the results of thermodynamic calculations for SiC substrate growth in a SiC-C equilibrium vapor pressure environment are depicted as double-dotted lines (Arrhenius plot).

In the present method, the SiC single crystal substrate E10 is grown by using the chemical potential difference and temperature gradient as growth driving force under the condition that the vapor pressure environment between the SiC material and the SiC substrate becomes the SiC-C equilibrium vapor pressure environment or SiC-C equilibrium vapor pressure environment. An example of this chemical potential difference is the partial pressure difference of gas phase species generated at the surface of SiC polycrystals and SiC single crystals.

When the partial pressure difference of the vapor generated from the SiC material (source) and the SiC substrate (transport destination) is considered as the growth amount, the SiC growth rate can be obtained by the following equation 1:

[Equation 1]

$$Growth\ rate \propto \sum_{i=SiC,Si_2C,SiC_2} \frac{(P_{transport\ souce\ i} - P_{transport\ destination\ i})}{\sqrt{2\pi m_i kT}}$$

where T is the temperature of the SiC material side, $m_i$ is the molecular weight of the gas phase species ($Si_xC_y$), and k is the Boltzmann constant. The $P_{transport\ source\ i}$ - $P_{transport}$ destination i is the growth amount where the source substrate gas becomes supersaturated and precipitated as SiC, and SiC, $Si_2C$, and $SiC_2$ are assumed as source substrate gases.

Therefore, the dashed line is the result of thermodynamic calculation when SiC single crystals are grown from SiC polycrystals in the vapor pressure environment when SiC (solid) and Si (liquid phase) are in phase equilibrium through a vapor phase. The results were obtained by thermodynamic calculations using the equation 1 under the following conditions (i) to (iv).

(i) The volume of the SiC-Si equilibrium vapor pressure environment is constant.
(ii) The growth driving force is the temperature gradient in the main container 20 and the vapor pressure difference (chemical potential difference) between the SiC polycrystals and SiC single crystals.
(iii) The source substrate gases are SiC, $Si_2C$, and $SiC_2$.
(iv) The adsorption coefficient of the source substrate on the steps of SiC single crystal substrate E10 is 0.001.

The double-dotted line is the result of thermodynamic calculation when SiC single crystals are grown from SiC polycrystals in the vapor pressure environment when SiC (solid phase) and C (solid phase) are in phase equilibrium through a vapor phase. The results were obtained by thermodynamic calculations using the equation 1 under the following conditions (i) to (iv).

(i) The volume of the SiC-C equilibrium vapor pressure environment is constant.
(ii) The growth driving force is the temperature gradient in the main container 20 and the vapor pressure difference (chemical potential difference) between the SiC polycrystals and SiC single crystals.
(iii) The source substrate gases are SiC, $Si_2C$, and $SiC_2$.
(iv) The adsorption coefficient of the source substrate on the steps of SiC single crystal substrate E10 is 0.001.

The data for each chemical species used in the thermodynamic calculations were used from JANAF thermochemical tables.

According to the graphs in Fig. 12, it can be understood that the trend of the results of growing the growth layer E11 on the SiC single crystal substrate E10 in the space having an atomic number ratio Si/C of more than 1 (in the main container 20) (marked with ∘) is consistent with the trend of the results of the thermodynamic calculations of SiC growth in a SiC-Si equilibrium vapor pressure environment. It can be understood that the trend of the results of growing the growth layer E11 on the SiC single crystal substrate E10 in the space (in the main container 20) having an atomic number ratio Si/C of 1 or less (marked with ×) is consistent with the trend of the results of thermodynamic calculations of SiC growth in the SiC-C equilibrium vapor pressure environment.

In a SiC-Si equilibrium vapor pressure environment, it can be understood that a growth rate of 1.0 $\mu$m/min or more is achieved at a heating temperature of 1960°C. It can also be understood that a growth rate of more than 2.0 $\mu$m/min is achieved at a heating temperature of 2000°C or higher. On the other hand, in the SiC-C equilibrium vapor pressure environment, it can be understood that a growth rate of 1.0 $\mu$m/min or more is achieved at a heating temperature of 2000°C. It can also be understood that a growth rate of 2.0 $\mu$m/min or more is achieved at a heating temperature of 2030°C or higher.

The present invention provides a novel technology that enables the growth of high-quality semiconductor substrates that simultaneously achieve the desired growth conditions in each of a plurality of base substrates.

Reference Signs List

| | |
|---|---|
| 1X | Unit object |
| 11 | Base substrate |
| 12 | Source substrate body |
| 13 | Substrate |
| 20 | Main container |
| 27 | Distance adjustment means |
| 28 | Source substrate transport prevention body |
| 30 | Heating furnace |
| 40 | Refractory material container |
| 50 | Separation means |
| 51 | Introduction means |
| 52 | Peeling means |
| 111 | Growth layer |
| 300 | Damaged layer |
| 511 | Oscillation means |
| 512 | Light collecting means |
| 1112 | Separation distance |
| S1 | Installation step |
| S2 | Heating step |
| S21 | Si atom sublimation step |
| S22 | C atom sublimation step |
| S23 | Etching step |
| S24 | Growth step |
| S3 | Separation step |
| S31 | Introduction step |
| S32 | Peeling step |

**Claims**

1. A method for producing a semiconductor substrate, comprising an installation step of alternately installing an base substrate and a source substrate body, and a heating step of heating the base substrate and the source substrate body to form a growth layer on the base substrate.

2. The producing method according to claim 1, wherein the installation step comprises installing the base substrate and the source substrate body in a semi-closed space.

3. The producing method according to claim 1 or 2, wherein the heating step comprises heating the base substrate and the source substrate body so as to form a temperature difference between them.

4. The producing method according to any one of claims 1 to 3, further comprising a separation step of separating a portion of the base substrate having the growth layer.

5. The producing method according to claim 4, wherein the separation step comprises an introduction step of introducing a damaged layer into the base substrate having the growth layer, and a peeling step of peeling a portion of the base substrate having the growth layer.

6. The producing method according to any one of claims 1 to 5, wherein the installation step installs the base substrate and the source substrate body so that they are in close contact with each other.

7. The producing method according to any one of claims 1 to 6, wherein the installation step installs a source substrate transport prevention body between the unit objects including the base substrate and the source substrate body to prevent source substrate transport between the base substrate and the source substrate body.

8. The producing method according to any one of claims 1 to 7, wherein the base substrate and the source substrate body comprise a SiC material.

9. An apparatus for producing a semiconductor substrate, comprising a main container capable of housing an base substrate and a source substrate body installed alternately, and a heating furnace capable of heating the base substrate and the source substrate body and forming a growth layer on the base substrate.

10. The producing apparatus according to claim 9, wherein the main container has a semi-closed space inside.

11. The producing apparatus according to claim 9 or 10, wherein the main container is capable of housing the base substrate, the source substrate body, the source substrate transport prevention body, the base substrate, and the source substrate body that are stacked in this order.

12. The producing apparatus according to any one of claims 9 to 11, wherein the heating furnace is capable of forming a temperature gradient between the base substrate and the source substrate body.

13. The producing apparatus according to any one of claims 9 to 12, further comprising a separation means capable of separating a portion of the base substrate having the growth layer.

14. The producing apparatus according to claim 13, wherein the separation means includes an introduction means capable of irradiating the base substrate having the growth layer with laser light and introducing a damaged layer to the base substrate having the growth layer, and a peeling means capable of peeling off a portion of the base substrate having the growth layer.

15. The producing apparatus according to any one of claims 9 to 13, wherein the base substrate and the source substrate body comprise a SiC material.

# FIG. 1

# FIG. 2

FIG. 3

EP 4 036 285 A1

*FIG. 4*

*FIG. 5*

## FIG. 6

## FIG. 7

*FIG. 8*

*FIG. 9*

(a)

(b)

(c)

(d)

# FIG. 10

(a)

(b)

*FIG. 11*

(a)

(b)

*FIG. 12*

## INTERNATIONAL SEARCH REPORT

| | International application No. |
|---|---|
| | PCT/JP2020/036000 |

A. CLASSIFICATION OF SUBJECT MATTER
C30B 29/36(2006.01)i; C30B 23/06(2006.01)i
FI: C30B29/36 A.; C30B23/06
According to International Patent Classification (IPC) or to both national classification and IPC

B. FIELDS SEARCHED

Minimum documentation searched (classification system followed by classification symbols)
C30B29/36; C30B23/06

| Documentation searched other than minimum documentation to the extent that such documents are included in the fields searched | |
|---|---|
| Published examined utility model applications of Japan | 1922–1996 |
| Published unexamined utility model applications of Japan | 1971–2020 |
| Registered utility model specifications of Japan | 1996–2020 |
| Published registered utility model applications of Japan | 1994–2020 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | WO 2017/188381 A1 (KWANSEI GAKUIN EDUCATIONAL FOUNDATION) 02 November 2017 (2017-11-02) claims 1, 5, paragraphs [0054], [0059], [0060], [0075], [0082], [0083], fig. 11 | 1-3, 8-10, 12, 15 |
| Y | | 4-5, 13-14 |
| A | | 6, 7, 11 |
| X | JP 2004-292305 A (THE NEW INDUSTRY RESEARCH ORGANIZATION) 21 October 2004 (2004-10-21) claim 1, paragraphs [0009]-[0014], [0029]-[0038], fig. 1-3 | 1-2, 8-10, 15 |
| Y | | 4-5, 13-14 |
| A | | 3, 6-7, 11-12 |
| X | JP 2008-16691 A (KWANSEI GAKUIN EDUCATIONAL FOUNDATION) 24 January 2008 (2008-01-24) paragraphs [0010], [0034], [0046], [0077], [0078], [0090]-[0095], fig. 1, 12A | 1-2, 6, 8-10, 15 |
| Y | | 4-5, 13-14 |
| A | | 3, 7, 11-12 |

☒ Further documents are listed in the continuation of Box C.    ☒ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 09 November 2020 (09.11.2020) | 08 December 2020 (08.12.2020) |

| Name and mailing address of the ISA/ | Authorized officer |
|---|---|
| Japan Patent Office | |
| 3-4-3, Kasumigaseki, Chiyoda-ku, | |
| Tokyo 100-8915, Japan | Telephone No. |

Form PCT/ISA/210 (second sheet) (January 2015)

**INTERNATIONAL SEARCH REPORT**

| International application No. |
| --- |
| PCT/JP2020/036000 |

C (Continuation).   DOCUMENTS CONSIDERED TO BE RELEVANT

| Category* | Citation of document, with indication, where appropriate, of the relevant passages | Relevant to claim No. |
| --- | --- | --- |
| X<br>Y<br>A | JP 2005-97040 A (THE NEW INDUSTRY RESEARCH ORGANIZATION) 14 April 2005 (2005-04-14) paragraphs [0016]-[0025], [0029], [0036], fig. 1 | 1-3, 6, 8-10, 12, 15<br>4-5, 13-14<br>7, 11 |
| X<br>Y<br>A | JP 2018-158858 A (NIPPON TELEGRAPH AND TELEPHONE CORP.) 11 October 2018 (2018-10-11) paragraphs [0001]-[0039], fig. 1, 3 | 1-2, 6-11, 15<br>4-5, 13-14<br>3, 12 |
| Y<br>A | JP 2017-500725 A (SILTECTRA GMBH) 05 January 2017 (2017-01-05) claims 1, 6 | 4-5, 13-14<br>1-3, 6-12, 15 |
| Y<br>A | WO 2019/004469 A1 (X-VI INCORPORATED) 03 January 2019 (2019-01-03) paragraph [0025] | 4-5, 13-14<br>1-3, 6-12, 15 |
| P, X<br><br>P, Y<br>P, A | JP 6720436 B1 (CUSIC INC.) 08 July 2020 (2020-07-08) claims 1, 2, paragraphs [0037]-[0039], [0048]-[0050] | 1-2, 6, 8-10, 15<br>4-5, 13-14<br>3, 7, 11-12 |

Form PCT/ISA/210 (continuation of second sheet) (January 2015)

**INTERNATIONAL SEARCH REPORT**

Information on patent family members

| | | International application No. |
|---|---|---|
| | | PCT/JP2020/036000 |

| Patent Documents referred in the Report | Publication Date | Patent Family | Publication Date |
|---|---|---|---|
| WO 2017/188381 A1 | 02 Nov. 2017 | US 2019/0136409 A1 claims 1, 5, paragraphs [0064], [0069], [0070], [0085], [0092], [0093], fig. 11 EP 3450595 A CN 109072478 A | |
| JP 2004-292305 A | 21 Oct. 2004 | US 2006/0249073 A1 claim 1, paragraphs [0013]-[0021], [0041]-[0003], fig. 1-3 | |
| JP 2008-16691 A | 24 Jan. 2008 | (Family: none) | |
| JP 2005-97040 A | 14 Apr. 2005 | (Family: none) | |
| JP 2018-158858 A | 11 Oct. 2018 | (Family: none) | |
| JP 2017-500725 A | 05 Jan. 2017 | US 2016/0254232 A1 claims 1, 6 EP 2859985 A2 DE 102014013107 A1 TW 201528357 A KR 10-2016-0068863 A CN 105899325 A | |
| WO 2019/004469 A1 | 03 Jan. 2019 | CN 110663097 A | |
| JP 6720436 B1 | 08 Jul. 2020 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H3295898 A
- JP 2013049161 A
- JP 2018207034 A
- JP 2017500725 A
- JP 2017526161 A
- JP 2018152582 A
- JP 2019500220 A
- JP 2019511122 A